Europäisches Patentamt

(19) European Patent Office

Office européen des brevets

(11) EP 0 807 978 A2

## (12) EUROPEAN PATENT APPLICATION

(43) Date of publication:
19.11.1997 Bulletin 1997/47

(21) Application number: 97107630.2

(22) Date of filing: 09.05.1997

(51) Int. Cl.6: **H01L 29/207**, H01L 29/167, H01L 29/227, H01L 29/24, H01L 33/00

(84) Designated Contracting States:
AT BE CH DE DK ES FI FR GB GR IE IT LI LU MC NL PT SE

(30) Priority: 10.05.1996 EP 96107454

(71) Applicant:
Paul-Drude-Institut für Festkörperelektronik
10117 Berlin (DE)

(72) Inventors:
• Brandt, Oliver
  10625 Berlin (DE)
• Yang, Hul,2 Paul-Drude Inst. für Festkörperelektr.
  100117 Berlin (DE)

(74) Representative:
Morgan, James G. et al
Robert-Koch-Strasse 1
80538 München (DE)

(54) **A method of fabricating a layer of high p-type conductivity in a semiconductor component and a semiconductor component having such a layer**

(57) A method of fabricating a p-conductive layer in a semiconductor component by doping a semiconductor material having a relatively large band-gap, for example a band-gap in the range from about 2.5 eV to about 7 eV, with a dopant acting as an acceptor is characterised in that at least one codopant is used in addition to said dopant, in an amount such that some of the acceptors formed by the dopant form ion pairs or complexes with said codopant. The use of this technique allows high p-type conductivities to be achieved in relatively large band gap materials. The description also relates to semiconductor components made in accordance with the method.

FIG 2B

EP 0 807 978 A2

Description

The present invention relates to a method of fabricating a layer of p-type conductivity in a semiconductor component by doping a semiconductor material having a relatively large band gap, for example a band gap in the range from about 2.5 eV to about 7 eV with a dopant acting as an acceptor. Futhermore, the present invention relates to semiconductor components having such a layer of p-type conductivity.

There are many semiconductor components for which it is desirable to use a semiconductor material having a relatively large band gap, for example in the above named range, where it would be of advantage to have higher conductivity of the p-type layers. Typical semiconductor components where this is desirable are, for example light-emitting diodes and laser diodes, where reliable operation is required at shorter wavelengths. For example, if it were possible to make a reliable and efficient laser operating with wavelengths in the blue light wavelength range, it would be possible to increase the storage capacity of compact disks by a factor of approximately 4, when compared with the red light laser diodes currently used. Other possible fields of application of semiconductor components with large band gap materials are high power and high temperature electronic devices such as bipolar transistors.

The problems relating to laser diodes with wavelengths in the blue region can be explained with reference to a new development comprising a GaN based injection laser diode, which has been fabricated on a sapphire substrate. This work has been reported in the "Journal of Applied Physics", Volume 35 L74 (1996) in the form of an article by S.Nakamura, M. Senoh, S. Nagahama, N. Iwasa, T. Yamada, T. Matsushita, H. Kiyoku and Y. Sugimoto.

For room temperature operation, this device requires pulsed injection to withstand the tremendously high pump power density of 120 kW/cm$^2$. This high power density results foremost from the large turn-on voltage of the device of 30 V, and secondarily, from the comparatively high threshold current-density of 4 kA/cm$^2$. The high voltage almost entirely drops within the p-type cladding layer of the stucture, since the conductivity of the p-type layer is low (5/Ωcm) and, consequently, the contact resistance is high (10$^{-2}$ Ωcm$^2$). The high current density is caused by the roughly etched facets of the laser structure, causing significant losses in wave-guiding the Fabry-Perot modes. This is described by S. Nakamura in Nikkei Electronics 1-15, 13 (1996).

Since the heat h dissipated in the structure is given by $h = j^2/\sigma$, where j is the current density and $\sigma$ the conductivity, the device would burn out if an attempt was made to operate under continuous wave (cw) conditions.

For achieving cw laser operation, it is thus required to reduce both the turn-on voltage and the threshold current-density. The latter task is most perfectly accomplished by synthesising GaN on a substrate which exhibits cleavage planes parallel to those of GaN, thus providing the possibility of defining the laser mirrors by cleaved facets which are atomically smooth. The former, more diffficult task requires an increase in the conductivity in p-type GaN. The conventional recipe for achieving a high conductivity consists firstly in searching for the the most sahallow impurity species in the material under consideration, and secondly in incorporating as much of this dopant as possible without degrading the quality of the host crystal. Extrapolating the knowledge acquired from doping studies of other III-V semiconductors, such as GaAs and GaP, to GaN, the potentially shallowest acceptor species is expected to be C, followed by Be, Mg, Zn, and Cd. For GaN, only doping by Mg and, recently, C has been found to result in p-type conductance. However, the activation energy of these acceptors is high (200 meV), and the atomic concentrations needed for hole densities in the mid 10$^{18}$ cm$^{-3}$ range is 10$^{20}$ cm$^{-3}$. This high density of impurities results in a very low hole mobility and, consequently, in a low conductivity. It is important to note that the high activation energy found experimentally is close to that determined for an ideal hydrogenic acceptor level in GaN, i.e. the material properties of GaN itself seem to impose a fundamental limitation to the conductivity one may be able to achieve.

The principle object underlying the present invention is to provide a method of enhancing the p-type conductivity in semiconductor materials, in particular in semiconductor materials having a relatively large band gap, so as to allow the fabrication of improved semiconductor devices. It is also an object of the present invention to provide such improved semiconductor devices having one or more p-type layers of enhanced conductivity. Furthermore, it is an object of the present invention to obtain the enhanced p-type conductivity without substantially complicating the manufacturing process that is used for forming the p-type layer or semiconductor component.

In a method of the initially named kind the solution of these objects is achieved, in acccordance with the invention, in that at least one codopant is used in addition to said dopant in an amount such that some of the acceptors formed by the dopant form ion pairs or complexes with said codopant.

It has been found that the use of a codopant in this way results in a substantial increase in conductivity and thus a decrease in resistivity. Initial investigations of this concept, which can be summarized as reactive co-doping, have, for example, shown that it is possible to increase the previously achieved conductivities of 5/Ωcm to 50/Ωcm and it seems reasonable to expect that further substantial increases will be possible as the technique is refined and ideal ratios of dopants to codopants are found.

It is possible to conceive of ion pair or ion complex formation where the elements concerned pair up or combine in space, i.e. in the crystal lattice, without reacting. More usually, however, the or each codopant will react with said dopant to form an ion pair or an ion complex in the crystal lattice, i.e. an ion pair or an ion complex which is localised in the crystal lattice, although a reaction as such is not essential to the present invention but rather only an affinity between the dopants and codopants leading to pairing up or grouping of atoms or molecules of the respective elements .

The semiconductor material used may, for example, be chosen from the group comprising binary, ternary, quarterary or pentanory compound semiconductors of elements from the classes III-V, IV-IV, II-VI of the periodic table of elements, e.g. GaN, AlN or $Ga_xAl_{1-x}N$, SiC, ZnS, CdZnS, ZnSe and diamond.

By way of example GaN has a band gap of 3.2 eV, SiC has a band gap of 3.0 eV, ZnS has a band gap of 2.7 eV, and C has a band gap of 5.2 eV.

The above named compound semiconductors are quoted by way of example and should not be understood as being an exhaustive list of the possible semiconductor materials.

In the methods of the above named kind the dopants and codopants are chosen from the groups of the periodic table such that the dopants are selected from groups one lower or one higher than the lowest group of the element or elements contained in the semiconductor material, and the codopants are selected from a group one higher or one lower than the highest group of the element or elements contained in the semiconductor material.

The dopants used, which form the acceptors in the p-type layer, are, for semiconductors based on III-V semiconductor materials, conveniently Be, Mg, C and Zn. Typical codopants, which form donators, and which react with the above acceptors, can be selected from O, S and Se. Again these substances should be understood as examples and not as being an exhaustive listing of the possible elements.

The doping density for said dopants preferably lies in the range from $10^{19}$ to $10^{21}$ $cm^{-3}$ and the doping density of the codopant or the sum of the doping densities of a plurality of codopants should be fractionally less, for example in the range of 80 to 99 % of the doping density of the dopants.

The dopant and codopant(s) are selected to provide a conductivity higher than obtainable without codopants through reduction of the number of both neutral and Coulomb scatterers and through a corresponding increase in the mobility of the holes.

It is a surprising finding of the present invention that the use of a codopant, which would ordinarily be expected to lower the conductivity, through a reduction in the number of holes, actually leads to such an increase in the mobility of the holes due to the reduction of the number of neutral and Coulomb scatterers that on balance a substantially higher conductivity can be achieved.

When a contact is to be made to a p-layer made in accordance with the present invention, this may be done through the use of a metallic ohmic contact, for example of Au or Pt, and this results in a low contact resistance preferably below $10^{-2}\Omega cm^2$.

Another advantage which stems from the method of the present invention is that it is readily possible to grow a layer of n-type conductivity on the layer of p-type conductivity using the selected codopant, for example O in GaN, in order to produce very high n-type conductivity, the n-type conductive layer consisting either of the same material as the p-type conductive layer or of a different semiconductor material.

One particular benefit which arises here is that there is no need to provide additional material for n-type doping in the epitaxial growth system. This growth system is preferably an MBE system , but could also be a MOVPE system, and indeed other epitaxial growth systems can probably also be adapted for use with the present invention.

It should be noted that it is a particularly surprising discovery of the present invention that oxygen is an extremely useful codopant. Hitherto substantial effort has been directed to keeping oxyen out of epitaxial growth systems. In actual fact, correctly metered, it has now been found to be an extremely valuable dopant material.

The method of the invention is extremely flexible. For example, the p-type conductive layer can be formed as a monolayer, or at least as a very thin layer, for example a $\delta$-doped layer, and can thus be extremely thin.

In another embodiment the ratio of the dopant material to the codopant material is varied through the thickness of the p-conductive layer in accordance with any desired doping profile to provide a layer of graded conductivity.

The present invention also relates to semiconductor components having p-conductive layers made in accordance with the methods of the invention . Preferred embodiments of the semiconductor components are set forth in the claims 12 to 23. It will be noted that there is no restriction of the invention to particular semiconductor devices, but rather it can be used in any devices, wherever p-conductive layers of high conductivity are required in materials having a relatively large band gap.

In order to provide experimental proof of the benefit of the present invention some experiments will now be described in which cubic GaN films are grown on GaAs substrates using solid-source molecular beam epitaxy.

This material combination is particularly interesting because, in accordance with the invention, it is possible to fabricate a laser diode in this way which is not only capable of continuous operation but which also permits easy fabrication of laser mirrors by the ability to cleave the semiconductor structure cleanly on parallel cleavage planes. These experiments show the initial results of carrying out reactive co-doping with Be as the acceptor species and O as the reactive codopant. As will be explained the initial experiments have already led to p-type conductivities in cubic GaN films as high as

50/$\Omega$cm. Preliminary p-n diodes exhibit clear rectifying behaviour with breakdown fields of 1 MV/cm. Despite the use of unsuitable contact metal in the experiments the donor contact resistance achieve for the p-n junctions in the initial experiments was already as low as $4 \times 10^{-2}\Omega$cm$^2$.

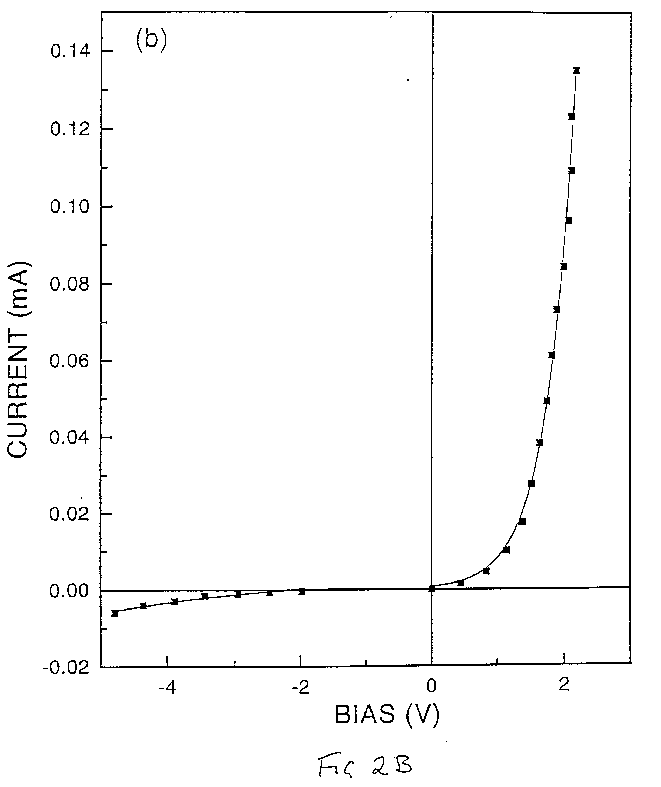

The experiments carried out will now be described with reference to the enclosed drawings of Figures 1, 2 and 3, in which are shown:

Fig. 1 an Arrhenius representation of the conductivity of p-type GaN layers grown under different conditions characteristic for two later explained regimes (iii) and (iv) with the squares representing the experimental data and the solid lines showing fits using a standard thermal activation model for the former and an exponential correlation for the latter sample,

Fig. 2A an I-V curve of a 400 nm thick free standing p-InGaN-nGaN heterojunction; the measurement points are based on raw data and the solid line shows the linear dependence of forward current on the voltage caused by the conduct resistance.

Fig. 2B shows an I-V curve for the same sample after the data has been corrected by subtracting the contact resistance; the solid line is a fit of an exponential to the forward part of the I-V map.

The experimental system will now be described.

The GaN films were synthesised by molecular beam epitaxy (MBE) on semiinsulating GaAs substrates oriented along [001], [011] and [113]. The base pressures reached in the two-chamber MBE system used were $10^{-8}$ and $5 \times 10^{-10}$ Torr in the loadlock and the growth chambers respectively. The system was equipped with elemental charges of Ga (7N purity), In (7N purity), As (6N purity) and Be (6N purity). Active N was generated by dissociating 6N purity N$_2$ gas, introduced through a mechanical leak valve, by a high voltage ($\sim$ 1.5 keV) plasma glow-discharge. The plasma power was kept constant for all experiments at 30 W.

The surface of the growing crystal was monitored in situ by reflection high energy electron diffraction (RHEED), using an incident angle between 1° and 2° and an acceleration voltage of 15 kV. Growth was initiated at a growth rate of 0.03 ML/s on the (2x4) reconstructed GaAs surface by closing As and simultaneously opening the N shutter. The pattern then invariably switched to an apparently N-induced (3x3) reconstruction, the nature of which is as yet unknown. Diffuse spots at the expected position for cubic GaN were observed next, which elongated and transformed to streaks within $\approx$100Å of GaN deposition. A predominantly streaky RHEED pattern, along with a clear 2x reconstruction along all major azimuths was observed after about 500 Å of deposition. The growth rate was then set to 0.1 ML/s, and p-type doping was initiated by opening the Be shutter, with the Be cell kept at 800-875°C corresponding to nominal incorporation rates of $10^{19}$-$10^{21}$ cm$^{-3}$. In order to avoid carrier loss to the low-gap GaAs substrate, i.e. to spatially confine holes provided by ionised Be acceptors within the doped layer, a few percent (5) of In were added to the doped layer which is deposited on the undoped GaN layer.

Hall measurements were performed by the van der Pauw and Hall-bar techniques, using either In or In/Ga contacts, or simply by touching the GaN layer with In-coated copper tips. Magnetic fields of 0.05-1 T were used, and currents between 1 and 300$\mu$A. To exclude any influence of the semiinsulating GaAs substrate, free-standing films of 400 nm thickness were measured after having removed the substrate with an H$_2$SO$_4$:H$_2$O$_2$ etch solution. The same method was applied when measuring the current-voltage characteristics of p-n junctions. The ohmic contacts used for the latter measurements were made of the In/Ga liquid alloy.

Undoped GaN layers grown in this system exhibited electron concentrations in the mid $10^{18}$ cm$^{-3}$ level and mobilities around 10 cm$^2$/Vs, regardless of whether growth is carried out under Ga-rich or N-rich conditions. This finding raises doubt about the commonly adopted interpretation as to which native defects, particularly N vacancies, are responsible for the high background electron concentration in undoped GaN. A decision was taken to measure electron concentrations when growing GaN layers immediately after having opened the system. Electron concentrations of up to $10^{21}$ cm$^{-3}$ were measured. It was noted that successive samples showed a monotonous decrease of electron concentration, with the standard background being reached after about ten growth runs. It was found that this decrease correlated with a decrease of the H$_2$O partial pressure (measured by quadrupole mass spectrometry) in the system, which drops from $10^{-9}$ Torr immediately after having opened the system, to $10^{-12}$ Torr in standard conditions. A decision was then taken to investigate whether O, supplied from residual H$_2$O vapor in the growth chamber, could be the actual reason for the background electron concentration in samples. A rough estimate, assuming a Ga beam equivalent pressure of $10^{-8}$ Torr at the growth rate used here, and unity sticking and dissociation coefficients for impinging H$_2$O molecules, yields atomic O concentrations between 0.01 % at standard conditions and 10 % with the highest H$_2$O partial pressure. In fact, subsequent Auger depth profiles reveal O concentrations on the order of 1 % in films exhibiting electron concentrations in the mid $10^{20}$ cm$^{-3}$ range. In contrast, for samples grown under standard conditions having electron concentrations in the mid $10^{18}$ cm$^{-3}$ range, the O concentration was below the detection limit (0.1 %) of Auger spectroscopy.

A decision was also taken to investigate the dependence of background electron concentration and thus, O incorporation, on the growth direction. GaN layers grown simultaneously on GaAs substrates oriented along [001], [011], and [113] which are mounted side-by-side on a Mo holder, were found to exhibit electron concentrations of $4.3 \times 10^{20}$ cm$^{-3}$, $1.1 \times 10^{20}$ cm$^{-3}$, and $1.5 \times 10^{20}$ cm$^{-3}$, respectively, indicating that the sticking coefficient of O is substantially reduced on both the (011) and the (113) planes when compared to the (001) plane. This result can be understood in terms of the different bonding configurations present on these surfaces. The incorporation of O is favored on surface sites with a Ga double dangling bond, the potential density of which is, under our growth conditions, highest on the (001) plane.

The strikingly high incorporation of O on substitutional (N) sites which is required for resulting in such high electron concentrations may be understood intuitively by considering the atomic properties of O with respect to N. The ionic radius of O is quite close to the values for the covalent and ionic radii of N, meaning that O will fit well on N sites without generating undue strain into the host lattice. Furthermore, the electronegativities of O and N are almost identical. From a chemical point of view, O is thus the ideal substitutional donor in GaN, and more detailed theoretical considerations in fact arrived at the same conclusion. In this respect reference should be made to D.W. Jenkins and J.D. Dow, Phys. Rev. B **39**, 3317 (1989). While $H_2O$ as the precursor for O doping is not desirable in MBE, $O_2$ or $O_3$ , possibly also as radicals produced a by plasma discharge for enhancing incorporation, are pumped effectively and are thus suitable precursors.

The achievement of p-type doping requires, first of all, an overcompensation of the high background electron concentration. As the latter is minimized when growth takes place on the (011) and (113) planes, and, simultaneously, the crystal quality of the GaN layers is reproducibly better for [113]-oriented growth than for either of the two other directions investigated here, a decision was taken to concentrate on this orientation for the p-type doping experiments. Secondly, the choice of Be as the acceptor species instead of the commonly used Mg was made in view of the fact that Be is, in all other III-V semiconductors, a more shallow acceptor than Mg. Furthermore, Be has other advantages over Mg such as less surface segregation, and is generally more easy to handle in MBE systems than Mg.

The results of the investigations can be summarized as follows:

(i) At nominal Be concentrations below $10^{20}$ cm$^{-3}$, n-type conductivity prevails.

(ii) At nominal Be concentrations of $10^{20}$ cm$^{-3}$ and high $H_2O$ partial pressure (>$3 \times 10^{-10}$ Torr), semiinsulating samples are obtained.

(iii) At nominal Be concentrations of $10^{20}$ cm$^{-3}$ and

"low" $H_2O$ partial pressure (<$2 \times 10^{-11}$ Torr), p-type conductivity is obtained with hole concentrations of about $5 \times 10^{18}$ cm$^{-3}$ and hole mobilities of 70 cm$^2$/Vs.

The high and "low" $H_2O$ partial pressures $3 \times 10^{-10}$ and $2 \times 10^{11}$ Torr roughly correspond to 1 and 0.07 % of incorporated O, i.e. about $10^{20}$ cm$^{-3}$ and $10^{19}$ cm$^{-3}$, respectively.

Two remarkable findings should be pointed out, namely (i) the high p-type conductivity of $50/\Omega$cm reached in the latter regime, and (ii) the high value for the hole mobility obtained for these samples. In fact, the high conductivity of our layers directly result from the high value for the mobility. Strikingly, the mobility values obtained are about one to two orders of magnitudes higher than those reported in the literature for a significantly lower degree of compensation due to residual impurities incorporated unintentionally into the sample and not measurable because of the low level. Reference is made here to C. Wang and R. Davis, Appl. Phys. Lett. **63**, 990 (1993); to T.T. Tanaka, A. Watanabe, H. Amonao, Y. Kobayashi, I. Akasaki, S. Yamazaki, and M. Koike, Appl. Phys. Lett. **65**, 593 (1994); and to M.E. Lin, G. Xue, G.L. Zhou, J.E. Greene, and H. Morkoc, Appl. Phys. Lett. **63** 932 (1993). Calculations of the influence of ionized and neutral impurity scattering on the mobility, being based upon the formalisms developed in the late 1950th's, indeed show that mobilities between 1 and 10 cm$^2$/Vs are to be expected at these impurity concentrations. These formalisms are discussed in the book "Semiconductor Physics" by K. Seeger, published in the Springer Series in Solid State Sciences Vol. 40, edited by M. Cardona, P. Fulde, K. von Klitzing, and H.-J. Queisser, (Springer, Berlin 1989, 4th Ed.). Slightly higher values are obtained when taking into account the degeneracy of the layer and the spatial donor-acceptor correlation. However, only a strict correlation of donors and acceptors in form of ion pairs which occupy nearest-neighbour sites reproduces the experimental mobility values, (see also R. Stratton, J. Phys. Chem. Solids 23, 1011 (1962), as the two individual, long-range Coulomb scatterers, are replaced in this case by a single, short-range dipole scatterer.

These results show that the high mobilities (and thus, conductivities) measured in the samples described are a result of the formation of ion pairs by ionized Be acceptors and O donors. In other words, it is the codoping of GaN with acceptors and donors which allows high mobility and thus high conductivity to be obtained.

The incorporation of Be might cause an enhanced and spatially correlated incorporation of O, such that perfectly compensated layers are obtained when O is available in a virtually unlimited amount (see regime (ii) above). However, once a surplus of Be is offered, p-type conductivity takes over. The important point here is that the number of isolated Coulomb scatterers just equals the surplus of Be, not the total concentration of Be and O.

It was decided, in the light of these findings, to grow samples under quite extreme conditions, namely, for an intentionally produced high $H_2O$ partial pressure achieved (by allowing atmospheric leakage into the growth chamber), and an extremely high Be flux.

This resulted in the discovery that in regime

(iv) at nominal Be concentrations of $10^{21}$ $cm^{-3}$ and high $H_2O$ partial pressure (>3x10$^{-10}$ Torr), p-type conductivity is obtained with hole concentrations of about $10^{18}$ $cm^{-3}$ and hole mobilities of 150 $cm^2/Vs$.

Auger spectrometry shows that such layers exhibit an O concentration of 2 %. The Be and O concentrations were measured by secondary ion mass spectrometry (SIMS) and were found to be Be = $5x10^{20}$ $cm^{-3}$ and O = $4.5x10^{20}$ $cm^{-3}$. The Be concentration has to be at least as high as that of O. The overall impurity concentration in these layers is thus higher than 4 %. Yet, the hole mobility measured for these samples is more than twice as high as the values obtained for samples grown under "low" $H_2O$ partial pressure (regime (iii)), a finding which would remain a paradox if donor-acceptor pair formation is neglected.

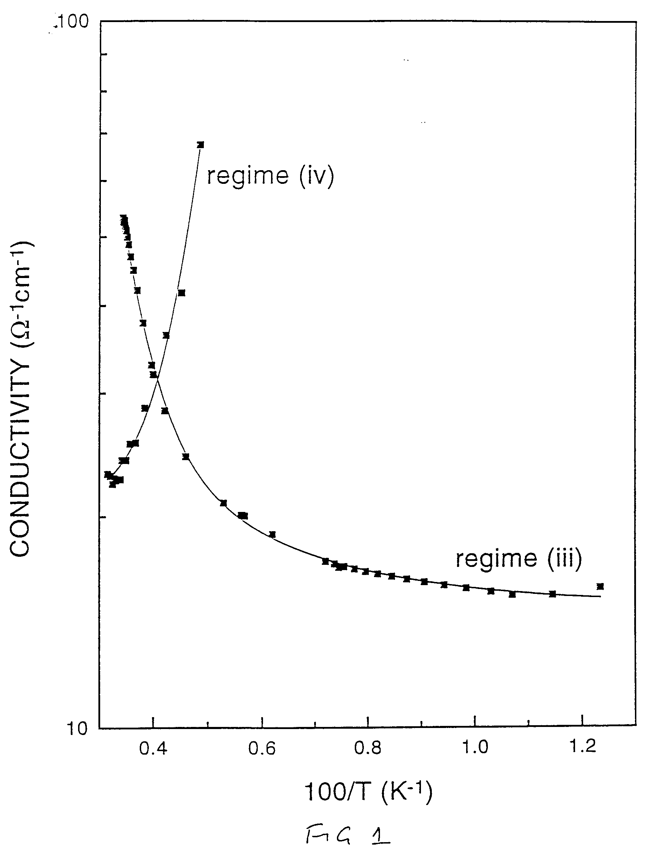

Figure 1 shows the Arrhenius representation of the conductivity of layers grown under conditions corresponding to regimes (iii) and (iv) as defined above. Whereas the former exhibit an activated conductivity, the latter are metallic in nature. The transitions between these different conductivity mechanisms is expected to occur at dopant concentrations $\eta$ as high that the wavefunctions of individual impurities overlap and thus form a band within the forbidden gap. Mathematically, this phenomenon is predicted at impurity concentrations satisfying the equation $a^3_B\eta \approx 1$, where $a^3_B$ is the Bohr radius of the (hydrogenic) impurity which can be estimated to be about 0.5 nm for Be. Correspondingly, the transition observed experimentally is expected to occur at Be concentrations of $2x10^{20}$ $cm^{-3}$, in agreement with the nominal Be concentration in these layers.

It also should be emphasized that, despite impurity concentrations in the regime of alloy formation, no degradation of crystal quality and surface morphology was observed. Besides the Hall measurements, the layers were investigated by double-crystal x-ray diffractometry, atomic force microscopy, ellipsometry, and Raman spectroscopy. The x-ray reflection profiles exhibit a clear (113) reflection from cubic GaN, with a width comparable to undoped GaN layers. The atomic force micrographs reveal values for the rms surface roughness of about 5 nm, which again is comparable to undoped layers, meaning that the surface morphology does not degrade even at this doping level. The smoothness of the layers is also reflected in ellipsometry, where pronounced interference fringes are detected below the band gap the magnitude of which agrees with simulated spectra. The layers are thus truly transparent below the band gap, which indicates that the concentration of deep levels generated by doping is fairly low. Moreover, the existence of a well-defined band gap at 3.35 eV reflects the single-crystal nature of the layers. Finally, in Raman spectra well-defined phonon-plasmon modes were observed which evidence the metallic character of the samples.

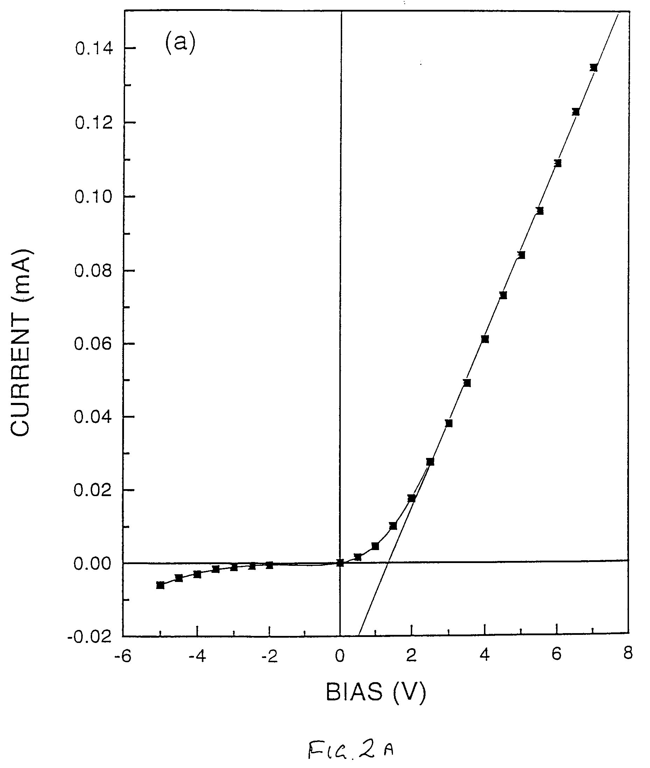

A practical semiconductor device in the form of a p-n junction was then fabricated in the form of a p-InGaN-n-GaN heterojunction for which the current-voltage (I-V) characteristics were measured. As mentioned above, all of the Be-doped layers are fabricated with a small percentage of In and are deposited on a thin layer of undoped (i.e., n-type) GaN. These structures thus represent, in principle, p-n heterojunctions, although the layers are too thin to allow accurate measurements. Nevertheless, the rectifying character of this structure is evident from the I-V measurements such as displayed in Fig. 2 (a). The linear behavior of the forward I-V curve is caused by the contact resistance of the junction, which was thus estimated to be about 4k$\Omega$. After subtracting the contact resistance, the forward current depends exponentially on voltage as shown in Fig. 2 (b). The turn-on voltage is about 1.5 V, and the breakdown of the p-n junction of 5 V of reverse bias corresponds to an electric field of $10^6$ V/cm, which is more than twice as high than that found for other III-V semiconductors such as GaAs and InP.

The experiments discussed above have shown that p-type room-temperature conductivities as high as 50/$\Omega$cm may be achieved in cubic GaN by the concept of reactive codoping using Be as the acceptor species and O as the reactive donor to render isolated Coulomb scatterers into dipole scatterers. The approach, however, is more general in nature and extends to other reactive impurity combinations (such as Mg and O) and also to other host materials, such as, particularly, the hexagonal modification of GaN. Furthermore, reactive codoping is not only possible when using MBE, but may be realized equally successfully by MOVPE users.

It will be noted that the present invention can be used with any semiconductor components or devices which have one or more layers of p-type conductivity, such as light-emitting diodes, rectifying diodes, laser diodes or bipolar transistors. It is not necessary to describe the layer structures of these components here since the basic layer structures are well known per se and the present invention lies in realising the p-type layer or layers using the codoping technique described herein.

**Claims**

1. A method of fabricating a p-conductive layer in a semiconductor component by doping a semiconductor material having a relatively large band-gap, for example a band-gap in the range from about 2.5 eV to about 7 eV, with a dopant acting as an acceptor, characterised in that at least one codopant is used in addition to said dopant, in an amount such that some of the acceptors formed by the dopant form ion pairs or complexes with said codopant.

2. A method according to claim 1, characterised in that the or each said codopant reacts with said dopant to form an ion pair or an ion complex in the crystal lattice.

3. A method in accordance with either of claims 1 and 2, characterised in that said semiconductor material is chosen from the group of binary, ternary, quarterary or pentanory compound semiconductors of elements from the classes III-V, IV-IV, II-VI of the periodic table of elements, e.g. GaN, AlN or $Ga_xAl_{1-x}N$, SiC, ZnS, CdZnS, ZnSe and diamond.

4. A method in accordance with any one of the preceding claims, characterised in that said dopants and codopants are chosen from the groups of the periodic table such that the dopants are selected from groups one lower or one higher than the lowest group of the element or elements contained in the semiconductor material, and the codopants are selected from a group one higher or one lower than the highest group of the element or elements contained in the semiconductor material.

5. A method in accordance with any one of the preceding claims, wherein, for a semiconductor based on III-V semiconductor materials, said dopants are acceptors such as beryllium, cadmium, magnesium and zinc, and the codopants are donators such as oxygen, sulfur and selenium.

6. A method in accordance with any one of the preceding claims, characterised in that the doping density for said dopant lies in the range $10^{19}$ up to $10^{21}$ $cm^{-3}$ and the doping density of said codopant or the sum of the doping densities of a plurality of codopants is fractionally less, for example in the range 80-99 % of the doping density of said dopants.

7. A method in accordance with any one of the preceding claims, characterised in that the dopant and codopant(s) are selected to provide a conductivity higher than that obtainable without codopants through reduction of the number of both neutral and Coulomb scatterers and a corresponding increase in mobility of the holes.

8. A method in accordance with any one of the preceding claims, wherein a contact is made to the p-layer, characterised in thatthe contact is a metallic ohmic contact, for example of Au or Pt and has a low contact resistance, preferably below $10^{-2}$ ohm $cm^{-2}$.

9. A method in accordance with any one of the preceding claims, characterised in that at least one n-conductive layer is grown on said p-conductive layer, using the co-dopant, for example O in GaN to produce very high n-conductivity, said n-conductive layer consisting of either the same material as said p-conductive layer, or of a different semiconducting material.

10. A method in accordance with any one of the preceding claims, characterised in that the p-conductive layer is a monolayer or at least a very thin layer, for example a $\delta$-doped layer.

11. A method in accordance with any one of the preceding claims, characterised in that the ratio of the dopant material to the codopant material is varied through the thickness of the p-conductive layer to provide a layer of gradient conductivity.

12. A semiconductor component having a layer of p-type conductivity formed by doping a semiconductor layer having a relatively large band gap, e.g. a band gap in the range from about 2.5 eV to about 7 eV, with a dopant acting as an acceptor, characterised in that the layer of p-type conductivity also includes at least one codopant in addition to said dopant, in an amount such that some of the acceptors formed by the dopant form ion pairs or complexes with said codopant.

13. A semiconductor component in accordance with claim 12, characterised in that the or each codopant reacts with said dopant to form an ion pair or an ion complex in the crystal lattice.

14. A semiconductr component in accordance with claim 12 or claim 13, characterised in that said semiconductor material is chosen from the group of binary, ternary, quarterary or pentanory compound semiconductors of elements from the classes III-V, IV-IV, II-VI of the periodic table of elements, e.g. GaN, AlN or $Ga_xAl_{1-x}N$, SiC, ZnS, CdZnS, ZnSe and diamond.

15. A semiconductor component in accordance with any one of the preceding claims 12 to 14 characterised in that said dopants and codopants are chosen from the groups of the periodic table such that the dopants are selected from groups one lower or one higher than the lowest group of the element or elements contained in the semiconductor material, and the codopants are selected from a group one higher or one lower than the highest group of the element or elements contained in the semiconductor material.

16. A semiconductor component in accordance with any one of the preceding claims 12 to 15 wherein, for a semiconductor based on III-V semiconductor materials, said dopants are acceptors such a beryllium, cadmium, magnesium and zinc, and the codopants are donators such as oxygen, sulfur and selenium.

17. A semiconductor component in accordance with any one of the preceding claims 12 to 16 characterised in that the doping density for said dopant lies in the range $10^{19}$ up to $10^{21}$ cm$^{-3}$ and the doping density of said codopant or the sum of the doping densities of a plurality of codopants is fractionally less, for example in the range 80-99 % of the doping density of said dopants.

18. A semiconductor component in accordance with any one of the preceding claims 12 to 17 characterised in that the dopant and codopant(s) are selected to provide a conductivity higher than that obtainable without codopants through reduction of the number of both neutral and Coulomb scatterers and a corresponding increase in mobility of the holes.

19. A semiconductor component in accordance with any one of the preceding claims 12 to 18 characterised in that the doping density for said dopant lies in the range $10^{19}$ up to $10^{21}$ cm$^{-3}$ and the doping density of said codopant or the sum of the doping densities of a plurality of codopants is fractionally less, for example in the range 80-99 % of the doping density of said dopants.

20. A semiconductor component in accordance with any one of the preceding claims 12 to 19 characterised in that at least one n-conductive layer is grown on said p-conductive layer, using the co-dopant, for example O in GaN to produce very high n-conductivity, said n-conductive layer consisting of either the same material as said p-conductive layer, or of a different semiconducting material.

21. A semiconductor component in accordance with any one of the preceding claims 12 to 20 characterised in that the p-conductive layer is a monolayer or at least a very thin layer, for example a δ-doped layer.

22. A semiconductor component in accordance with any one of the preceding claims 12 to 21 characterised in that the ratio of the dopant material to the codopant material is varied through the thickness of the p-conductive layer to provide a layer of gradient conductivity.

23. A said semiconductor component comprises a light emitting diode, a rectifying diode, a laser diode, a bipolar transistor, or any device requiring a p-type layer or a circuit formed on a chip and including at least one of the aforesaid components.

FIG 1

FIG. 2A

Fig 2B